Europäisches Patentamt

European Patent Office

Office européen des brevets

(19)

(11) **EP 1 133 499 B1**

(12) **EUROPÄISCHE PATENTSCHRIFT**

(45) Veröffentlichungstag und Bekanntmachung des Hinweises auf die Patenterteilung:
**12.02.2003 Patentblatt 2003/07**

(51) Int Cl.[7]: **C07F 7/00**, C07F 9/00, C23C 16/40

(21) Anmeldenummer: **99960855.7**

(22) Anmeldetag: **02.11.1999**

(86) Internationale Anmeldenummer:
**PCT/DE99/03495**

(87) Internationale Veröffentlichungsnummer:
**WO 00/032608 (08.06.2000 Gazette 2000/23)**

(54) **KOMPLEXVERBINDUNG EINES ELEMENTS DER IV NEBENGRUPPE**

COMPLEX COMPOUND OF AN ELEMENT OF SUB-GROUP IV OR V

COMPOSE COMPLEXE D'UN ELEMENT DU GROUPE IV OU V

(84) Benannte Vertragsstaaten:
**DE FR GB IE IT**

(30) Priorität: **26.11.1998 DE 19854640**

(43) Veröffentlichungstag der Anmeldung:
**19.09.2001 Patentblatt 2001/38**

(73) Patentinhaber: **SIEMENS AKTIENGESELLSCHAFT**
**80333 München (DE)**

(72) Erfinder:
• **HINTERMAIER, Frank**
**D-81547 München (DE)**
• **METZGER, Ralf**
**D-80805 München (DE)**
• **WERNER, Christoph**
**D-85665 Moosach (DE)**

(74) Vertreter: **Ginzel, Christian et al**
**Zimmermann & Partner,**
**Postfach 33 09 20**
**80069 München (DE)**

(56) Entgegenhaltungen:
**WO-A-95/26355**

• **CHEMICAL ABSTRACTS, vol. 128, no. 14, 6. April 1998 (1998-04-06) Columbus, Ohio, US; abstract no. 174409, ITSUKI, ATSUSHI ET AL: "Tantalum compound for vapor deposition" XP002131327 & JP 10 036379 A (MITSUBISHI MATERIALS CORP., JAPAN) 10. Februar 1998 (1998-02-10)**
• **CHEMICAL ABSTRACTS, vol. 99, no. 24, 12. Dezember 1983 (1983-12-12) Columbus, Ohio, US; abstract no. 205066, NARULA, A. K. ET AL: "Preparation and characterization of tantalum(V).beta.-diketonates. (Par II)" XP002131328 & SYNTH. REACT. INORG. MET.-ORG. CHEM. (1983), 13(7), 887-98 ,**
• **KAPOOR, R. N. ET AL: "Organic compounds of niobium and tantalum. Reactions of niobium and tantalum pentaethoxides with dibenzoylmethane" BULL. CHEM. SOC. JPN. (1967), 40(6), 1384-6 , XP002131326**

EP 1 133 499 B1

**Beschreibung**

Die Erfindung betrifft eine Precursorkombination zur Abscheidung von SBT zum Einsatz in der Chemical Vapor Deposition (CVD)-Technik. Als Precursorkombination wird das Stoffgemisch (z.B. der Metallkomplex oder Precursor und ein Lösungsmittel) bezeichnet, das am Beginn der CVD-Reaktion verdampft wird.

Aus der US 5 820 664 sind Precursorkombinationen bekannt. Für die CVD Abscheidung von z.B. $SrBi_2Ta_2O_9$ (SBT) wird eine Precursorkombination mit [Ta(OiPr)$_4$thd] (vgl. Sp.6;Z.42) eingesetzt, die einen Ta-Komplex mit einem Alkoxidliganden mit $\alpha$-ständigem Proton und damit ein potentielles Reduktionsmittel (unter Bildung des entsprechenden Ketons) enthält.

Um stabile $Bi_2O_3$-Abscheideraten zu erhalten wurde der Precursor Bi(Ph)$_3$ durch Bi(thd)$_3$ ersetzt (vgl. F. Hintermaier et al. Vortrag auf dem International Symposium on Integrated Ferroelectrics, Monterey, CA, USA, 1998). In Anwesenheit eines Reduktionsmittels wird Bi(thd)$_3$ jedoch leicht zum Metall reduziert. Dazu wird vom Precursor [Ta(OiPr)$_4$thd] z.B. durch Hydrolyse HOiPr freigesetzt, das als Reduktionsmittel wirkt oder in einer Ligandenaustauschreaktion nach

$$Ta(OiPr)_4thd + Bi(thd)_3 \rightarrow Ta\ (thd)_2(OiPr)_3 + Bi\ (thd)_2(OiPr)$$

Bi(thd)$_2$ (OiPr) bildet, das in einer internen Redoxreaktion unter Reduktion des $Bi^{3+}$ Metallions elementares Wismut freisetzt.

Aufgabe der Erfindung ist es daher, eine neue Precursorkombination zur Verfügung zu stellen, die sich zum Abscheiden von SBT eignet und die Ta-Komplexverbindungen enthält, die bei der CVD-Abscheidung mit einem $Bi^{3+}$ Precursor stabil bleiben und/oder im Falle einer Ligandenaustauschreaktion die Bildung eines unter den Reaktionsbedingungen der CVD-Technik thermisch stabilen Nebenprodukts fördern, das Wismut weiter in oxidierter Form enthält.

Diese Aufgabe wird erfindungsgemäß gelöst durch die Precursorkombination gemäß dem unabhängigen Anspruch 1 sowie durch die Verwendung dieser Precursorkombination zur CVD-Abscheidung von SBT gemäß Anspruch 2.

Gegenstand der Erfindung ist eine Precursorkombination zur Abscheidung von SBT, umfassend die Verbindungen:

Sr(thd)$_2$(pmdeta) oder Sr(thd)$_2$(tetraglyme),
Bi(thd)$_3$ und
Ta(thd)(OtBu)$_4$ oder Ta(thd)(OtPe)$_4$,

wobei thd 2,2,6,6-Tetramehtyl-3,5-heptandionat und pmdeta Pentamethyldiethylentriamin bedeuten.

Weiterhin ist Gegenstand der Erfindung die Verwendung dieser Precursorkombinationen zur Abscheidung von SBT.

Die Precursorkombinationen gemäß Anspruch 1 enthalten als Ta-Komplexbildner nur Alkoxide ohne $\alpha$-ständigem Proton und sterisch sehr anspruchsvolle Liganden.

Die Ta-Komplexe in den Precursorkombinationen der vorliegenden Erfindung fallen unter die allg. Formel

$$M\ (L)_x(R_3C\text{-}0\text{-})_{y\text{-}x}$$

wobei
M ein stabiles Zentralatom aus der IV oder V Nebengruppe des Periodensystems ist,
L ein $\beta$-Diketonat; ein $\beta$-Ketiminat und/oder ein $\beta$-Diiminat

**(R$_3$C-O-)** ein Alkoxidligand, bei dem **R** gleich oder verschieden sein kann und einen Alkylrest mit 1 bis 24 C-Atomen bezeichnet, der verzweigt oder geradkettig und ggf substituiert und/oder komplexiert sein kann

**x** ungleich Null und eine Zahl zwischen 1 und 4 ist und
**y** ungleich Null und je nach Oxidationsstufe des Zentralatoms 2,3,4 oder 5 ist.

In den erfindungsgemäßen Precursorkombinationen wird Tantal als Zentralatom des Komplexes eingesetzt.

Als tertiärer Rest am Alkoxidliganden wird der tert.-Butylund/oder der tert.-Pentylrest eingesetzt.

Als sterisch anspruchsvoller Ligand wird das thd, ein 2,2,6,6-Tetramethyl-3,5-heptandionat, eingesetzt.

In den Ta-Komplexen der erfindungsgemäßen Precursorkombinationen sind 4 Alkoxidliganden mit einem (thd) Liganden am Zentralatom des Komplexes gebunden.

Als Alkoxidligand wird der über das Sauerstoffatom der Alkoholgruppe gebundene Alkoholat-Ligand bezeichnet, der die allgemeine Formel

$$-O-CR_3$$

hat, wobei **R** gleich oder verschieden sein kann und einen Alkylrest mit 1 bis 24 C-Atomen bezeichnet, der verzweigt oder geradkettig und ggf substiuiert und/oder komplexiert sein kann. Dabei ist es vorteilhaft, wenn z.B. der Alkoholat-Ligand noch Ether, Amin und/oder Sulfidgruppen enthält, welche eine zusätzliche Donorfunktion gegenüber dem Zentralatom übernehmen können.

Die Alkoxidliganden in den Tantalkomplexen der erfindungsgemäßen Precursorkombinationen fallen unter die allg. Formel:

$$-0-C(CH_3)_{3-n}[(CH_2)_m-CH_3]_n$$

wobei

n Werte von 0-3 und

m Werte von 0-3

annehmen kann.

In den Tantalkomplexen werden Derivate eines β-Diketonats eingesetzt.

Speziell wird das 2,2,6,6-Tetramethyl-3,5-heptandionat eingesetzt. Andere Liganden sind z.B. das Acetylacetonat (acac); das Hexafluoropentandionat (hfac); 1,1,1-Trifluoro-2,4-pentandionat (tfac); 6,6,7,7,8,8,8-Heptafluoro-2, 2-dimethyl-3,5-octandionat; 2,2,7-Trimethyl-3,5-octandionat; 1,1,1,5,5,6,6,7,7,7-Dekafluoro-2,4-heptandionat; und schließlich das 1,1,1-Trifluoro-6-methyl-2,4-dionat.

Die Herstellung des Komplexes erfolgt über eine Ligandenaustauschreaktion nach dem folgenden Muster:

Ausgegangen wird von einem niedrigen Tantal-Alkoxid, wie z.B. dem $Ta(thd)_p(OMe)_{5-p}$ (p kann Werte von 1 bis 4 annehmen). Zur Darstellung wird dieses in einem Alkohol, z.B. tertiärem Butyl- oder Pentylalkohol unter Zusatz von Benzol gelöst und unter Rückfluß und gleichzeitigem Abdestillieren des frei werdenden Alkohols (Verschiebung des Gleichgewichts zu Gunsten der Bildung des neuen Komplexes), hier des Methanols, gekocht.

Der Komplex $Ta(thd)(OtBu)_4$, hat als Precursor den Vorteil, daß er im Falle einer Reaktion mit $Bi(thd)_3$ unter Bildung der thermisch stabilen Verbindung $Bi(thd)_a(OtBu)_b$ (wobei a und b jeweils die Werte 1 oder 2 annehmen kann) reagiert. Außerdem wird bei der unter Umständen auftretenden Hydrolyse als Alkohol das tBuOH frei, das kein α-ständiges Proton hat und deshalb nicht als Reduktionsmittel wirkt.

$Ta(thd)(OtBu)_4$ hat ähnliche Verdampfungseigenschaften wie $Ta(thd)(OiPr)_4$, weil beide Verbindungen ähnliche Molekularmassen haben.

Die beschriebenen Komplexe, insbesondere die des Tantals, sind aber nicht nur zur Abscheidung von SBT nützlich. Vielmehr können sie generell zur CVD-Abscheidung von Dünnfilmen auf Metalloxidbasis eingesetzt werden.

Derartige Dünnfilme finden Anwendung z.B. in der Speichertechnik, z.B. für Dynamic Random Access Memories (DRAMs) und Ferroelectric Random Access Memories (FeRAMs).

Hier läßt sich auch an den Einsatz zur Abscheidung von Tantalpentoxid denken, welches in zukünftigen DRAMs-Generationen als Dielektrikum Einsatz finden wird.

## Patentansprüche

1.    Precursorkombination zur Abscheidung von $SrBi_2Ta_2O_9$ (SBT), umfassend die Verbindungen,

-    $Sr(thd)_2(pmdeta)$ oder $Sr(thd)_2(tetraglyme)$,
-    $Bi(thd)_3$ und
-    $Ta(thd)(OtBu)_4$ oder $Ta(thd)(OtPe)_4$,
-    wobei thd 2,2,6,6-Tetramethyl-3,5-heptandionat und pmdeta Pentamethyldiethylentriamin bedeuten.

2.    Verwendung der Precursorkombination nach Anspruch 1 zur Abscheidung von $SrBi_2Ta_2O_9$ (SBT).

## Claims

1.    Precursor combination for the deposition of $SrBi_2Ta_2O_9$, (SBT), comprising the compounds

-    $Sr(thd)_2(pmdeta)$ or $Sr(thd)_2(tetraglyme)$,

- Bi(thd)$_3$ and
- Ta(thd) (OtBu)$_4$ or Ta(thd) (OtPe)$_4$,
- where thd is 2,2,6,6-tetramethyl-3,5-heptanedionate and pmdeta is pentamethyldiethylenetriamine.

2. Use of the precursor combination according to Claim 1 for the deposition of SrBi$_2$Ta$_2$O$_9$ (SBT).

**Revendications**

1. Combinaison formant précurseur pour le dépôt de SrBi$_2$Ta$_2$O$_9$ (SBT) comprenant les composés,

- Sr(thd)$_2$(pmdeta) ou Sr(thd)$_2$(tétraglyme),
- Bi(thd)$_3$ et
- Ta(thd)(OtBu)$_4$ ou Ta (thd (OtPe)$_4$,
- thd signifiant le 3,5-heptanedionate de 2,2,6,6-tétraméthyle et pmdeta signifiant la pentaméthyldiéthylènetriamine.

2. Utilisation de la combinaison formant précurseur suivant la revendication 1 pour le dépôt de SrBi$_2$Ta$_2$O$_9$ (SBT).